**Europäisches Patentamt**

(19) **European Patent Office**

**Office européen des brevets**

(11) Numéro de publication: **0 055 639**
**B1**

(12) **FASCICULE DE BREVET EUROPEEN**

(45) Date de publication du fascicule du brevet:
**03.07.85**

(21) Numéro de dépôt: **81401855.2**

(22) Date de dépôt: **23.11.81**

(51) Int. Cl.⁴: **G 11 C 7/00, H 04 B 5/00**

(54) Système de transmission d'information à transducteur programmable passif pour codage dynamique.

(30) Priorité: **26.11.80 FR 8025035**

(43) Date de publication de la demande:
**07.07.82 Bulletin 82/27**

(45) Mention de la délivrance du brevet:
**03.07.85 Bulletin 85/27**

(84) Etats contractants désignés:
**BE DE FR GB IT NL SE**

(56) Documents cités:
**DE - A - 2 419 081**
**GB - A - 1 462 054**
**US - A - 3 996 554**

**TECHNISCHE MITTEILUNGEN AEG-TELEFUNKEN, Heft 61, no. 6, 1971, pages 333-337, BERLIN (DE), H. EDLICH: "Automatisierungssystem mit induktiver Übertragung Logitrans für eine Erzumschlaganlage"**

(73) Titulaire: **Saulnier, Dominique, 37-39, allée du Closeau, F-93160 Noisy le Grand (FR)**

(72) Inventeur: **Saulnier, Dominique, 37-39, allée du Closeau, F-93160 Noisy le Grand (FR)**

(74) Mandataire: **Sauvage, Renée, CABINET SAUVAGE 100 bis, avenue de Saint-Mandé, F-75012 Paris (FR)**

ACTORUM AG

## Description

La présente invention a pour objet un système de transmission d'informations à transducteur programmable pour codage dynamique.

La fonction de codage dynamique consiste à enregistrer et à mémoriser dans un dispositif mobile et à restituer, sans contact ni liaison électrique, et sans alimentation électrique, des informations variables qu'un dispositif fixe lui a communiquées, sans contact ni liaison électrique.

Actuellement, le codage dynamique se fait de trois manières:

a) avec des dispositifs à base de doublets magnétiques qui, suivant leur polarité magnétique, modifient la fréquence d'un oscillateur en $\pm \Delta f$, l'interprétation du sens de $\Delta f$ est associée à un élément d'information (bit) 1 ou 0.

Les inconvénients de ce système sont que l'information est transmise sous forme parallèle et de ce fait la dimension du système est liée à l'importance de cette information, que le système de décodage et onéreux et compliqué et que le matériau constituant les doublets magnétiques est très spécial et d'approvisionnement délicat.

b) avec une batterie d'émetteurs de fréquence qui agissent sur une batterie de récepteurs de fréquence: les informations reçues actionnent des relais bistables qui mettent ou non en œuvre des émetteurs de fréquence différents des précédents et qui restituent leur fréquence à une batterie de récepteurs eux-mêmes distincts des précédents. Les inconvénients de ce système apparaissent dans le fait que l'information est transmise sous forme parallèle et que la dimension du système est liée à l'importance de cette information (cette dimension est augmentée par le fait que les émetteurs interfèrent entre eux et qu'il faut donc les éloigner), dans le fait que la mémorisation est obtenue par des relais bistables qui peuvent offrir des aléas de contact dans des cas de vibration et dans le fait qu'il faut beaucoup de moyens à mettre en œuvre, beaucoup de câblages et, donc une altération de la fiabilité.

c) avec au moins un dispositif mobile alimenté en énergie par des dispositifs fixes avec lesquels il échange des informations, ces informations étant codées et modulant une onde porteuse.

Par ailleurs, pour résoudre le problème de la téléalimentation du dispositif mobile, on connaît, d'après le document DE-A 2 419 081 un dispositif de transmission d'informations sans contact, comportant un récepteur d'informations fixe alimentant par induction un émetteur d'informations mobile. Ce dispositif connu ne permet ni de mémoriser des informations dans l'émetteur, ni d'envoyer d'informations ou d'ordres du récepteur vers l'émetteur, ni à plus forte raison de sélectionner ou de modifier les informations émises par l'émetteur.

D'autre part, pour résoudre le problème de la multiplicité d'émetteurs et de récepteurs, on connaît d'après le document «Technische Mitteilung AEG Telefunken», vol. 6, n° 6, 1971, pages 333 à 337 un système de transmission bidirectionnelle d'informations par induction entre un dispositif stationnaire et un dispositif mobile. Ce système ne permet pas non plus de mémoriser dans le dispositif mobile des informations provenant par exemple d'un premier dispositif stationnaire pour les retransmettre ultérieurement à un second dispositif stationnaire.

La présente invention a pour objet un système de transmission d'informations par induction entre plusieurs dispositifs fixes et plusieurs dispositifs mobiles, les dispositifs mobiles pouvant mémoriser des informations transmises par les dispositifs fixes, et pouvant transmettre aux dispositifs fixes des informations issues des informations mémorisées, ces dernières pouvant avoir été modifiées par l'arrivée d'autres informations à mémoriser, cy système de transmission d'informations étant le plus simple possible et le moins onéreux possible.

Le système de transmission d'informations par induction conforme à l'invention comporte au moins un dispositif mobile (appelé par la suite «plot programmable») alimenté par induction en énergie par des dispositifs fixes (appelés par la suite «séquenceur de programmation» lorsqu'ils émettent des informations vers les dispositifs mobiles, et «plot de lecture» lorsqu'ils reçoivent des informations de ces dispositifs mobiles) avec lesquels il échange des informations, ces informations étant codées et modulant une onde porteuse, et ce système est caractérisé:

– en ce que le séquenceur de programmation comporte un «modulateur» ou dispositif de codage et de mise en forme d'informations, branché entre une source d'informations à programmer et un dispositif de modulation d'une onde porteuse;

– en ce que le séquenceur de programmation comporte également un «démodulateur» ou dispositif de décodage pouvant décoder des informations telles que codées et mises en forme par le modulateur, branché entre un circuit de réception inductive d'informations et un comparateur qui est relié d'autre part à ladite source d'informations à programmer, ce comparateur comportant une sortie d'égalité et une sortie de défaut;

– en ce que le plot programmable comporte un démodulateur, identique au démodulateur du séquenceur de programmation, branché entre un circuit de réception inductive d'informations et un circuit de mémorisation à mémoire à semiconducteur;

– en ce que le plot programmable comporte également un modulateur identique à celui du séquenceur de programmation, ce modulateur étant branché entre le circuit de mémorisation et un dispositif interrupteur statique branché dans un circuit inductif accordé;

– en ce que le plot de lecture comporte un démodulateur identique aux démodulateurs précités, ce démodulateur étant branché entre un circuit de réception inductive d'informations et une mémoire temporaire effaçable restituant à la demande les informations qu'elle mémorise;
– en ce que le plot de lecture comporte un oscillateur de puissance alimentant de façon permanente par induction le plot programmable lorsqu'ils sont en regard l'un de l'autre, la sortie de cet oscillateur étant également reliée à l'entrée de signaux d'horloge du démodulateur, et
– en ce que le séquenceur de programmation comporte un oscillateur de puissance alimentant par induction de façon permanente, le plot programmable lorsqu'ils sont en regard l'un de l'autre, la sortie de cet oscillateur étant également reliée à l'entrée de signaux d'horloge du démodulateur et du modulateur de ce séquenceur.

Le système objet de l'invention peut être commandé par un système, par exemple à base de microprocesseur, qui lui fournit les informations à mémoriser et qui est susceptible de dialoguer avec lui.

On va maintenant exposer succinctement des modes de réalisation préférés du séquenceur de l'invention.

Le séquenceur reçoit sur ses entrées l'information à enregistrer dans le plot programmable. Une entrée permet d'écrire cette information, sans contact ni liaison électrique, dans ce plot programmable. Pour ce faire, le séquenceur de programmation convertit sous forme série les informations parallèles en leur incluant des bits de synchronisation et de parité, et en modulant la largeur de ces bits.

Le plot programmable reçoit cette information, se synchronise et teste la validité de la transmission. L'information reçue, correcte, est mise sous forme parallèle, et un signal de validation permet de transférer cette information dans une mémoire dont les cellules sont validées. Les signaux de sortie de la mémoire sont mis sous forme série. Le plot programmable inclut des informations de synchronisation (combinaison unique de bits) et de parité. L'information, ainsi structurée, est retournée du plot programmable vers le séquenceur de programmation (sans contact ni liaison électrique) en actionnant un interrupteur statique qui ferme ou ouvre une boucle active constituée d'une spire gravée sur circuit imprimé et d'un condensateur.

Le séquenceur de programmation analyse et teste cette information, puis la restitue sous forme parallèle. L'information parallèle à programmer est comparée à l'information parallèle reçue dans le séquenceur de programmation. En cas d'égalité, le séquenceur de programmation délivre un signal qui indique que le plot programmable a enregistré une information correcte, sinon une sortie «défaut de programmation» est activée. Dans le cas d'une lecture par un plot de lecture, le plot programmable met en œuvre l'interrupteur statique qui ferme ou non une boucle active, constituée d'une spire gravée sur circuit imprimé et d'un condensateur, au rythme de l'information enregistrée par le plot programmable. Cette information enregistrée par le plot programmable est mise sous forme série et, le plot programmable insère des informations de synchronisation et de parité.

Le plot de lecture se synchronise sur cette information et teste la parité, ensuite cette information est transmise sous forme parallèle aux interfaces de sortie du plot de lecture. Pour ce faire, le séquenceur de programmation (fonction: lecture) et le lecteur disposent d'un oscillateur de puissance raccordé à une bobine d'émission concentrique à une bobine de signal associée à un oscillateur de signal. Les fréquences de l'oscillateur de puissance et de l'oscillateur de signal sont différentes et, les deux oscillateurs sont en service en même temps. De plus, le séquenceur de programmation dispose d'une bobine de programmation coplanaire aux bobines de puissance et de signal. A cette bobine est associé un oscillateur de programmation qui est mis en œuvre au rythme du signal série, transformé des informations parallèles à enregistrer dans le plot programmable.

Le plot programmable comprend une bobine de réception accordée sur la fréquence de l'oscillateur de puissance, une bobine de réception accordée à la fréquence de l'oscillateur de programmation, un circuit résonant série constitué d'un interrupteur statique, d'une spire gravée sur circuit imprimé et d'un condensateur d'accord. Ce circuit résonant série et accordé sur la fréquence de l'oscillateur de signal. Lorsqu'un plot de lecture est en regard du plot programmable, la bobine accordée sur la fréquence de l'oscillateur de puissance est le siège d'une force électromotrice induite de valeur élevée. Cette force électromotrice est redressée, filtrée et fournit une tension d'alimentation continue au plot programmable. L'information présente dans le moyen de mémorisation du plot programmable sous forme parallèle est mise sous forme série par un convertisseur, cette information série transite dans un modulateur d'émission dont la fonction est d'inclure au message série des informations de synchronisation, de calculer et d'inclure un bit de parité, de distinguer un bit «1» d'un bit «0» par exemple en modulant la largeur du signal élémentaire de base. La sortie du modulateur attaque, par un adaptateur de niveau, un interrupteur statique. Cet interrupteur statique ferme ou ouvre, au rythme du signal de sortie du modulateur, un circuit résonant série accordé sur la fréquence de l'oscillateur de signal du plot de lecture. Lorsque l'interrupteur statique est fermé, le circuit résonant série est formé. De ce fait, le plot programmable prélève de l'énergie, par courants de Foucault, à l'oscillateur de signal. Lorsque l'interrupteur statique est ouvert, le circuit résonant série n'est pas formé et, de ce fait, le plot programmable ne prélève pas d'énergie au plot de lecture. Donc, suivant le signal issu de la sortie du modulateur du plot programmable, le plot programmable prélève ou non de l'énergie au plot de lecture. Cette modification d'énergie est traitée pour fournir un signal tout ou rien, image du signal tout ou rien issu du modulateur du plot programmable, lui-même étant la traduction de l'information enregistrée dans la mémoire du plot programmable.

Le signal tout ou rien élaboré dans le plot de lecture est dérivé vers un démodulateur dont la fonction est de reconnaître l'information de synchronisation et d'élaborer, dès cette reconnaissance faite, le processus de reconnaissance de l'information en traduisant en une succession de signaux tout ou rien de niveau «1» ou «0» des signaux modulés, par exemple en largeur, en testant la parité et en élaborant un signal de validation ou non suivant qu'il s'agit d'une information sans ou avec défaut de transmission.

La succession de signaux tout ou rien issue du démodulateur du plot de lecture est dirigée vers un convertisseur qui convertit ce signal série en signaux parallèles. Ces signaux parallèles sont envoyés sur les entrées d'une mémoire temporaire. La mise en mémoire et assurée ou non par la présence ou non du signal de validation élaboré par le démodulateur. La sortie des cellules mémoire actionne les interfaces de sortie du plot de lecture de manière à reconstituer l'information résidente dans le plot programmable. De plus, une entrée supplémentaire permet de mettre les sorties parallèles en haute impédance sous la commande dudit système.

Le séquenceur de programmation dispose de trois fonctions distinctes qui peuvent intervenir simultanément. A savoir: une fonction de lecture du plot programmable, une fonction de programmation du plot programmable et une fonction de comparaison de l'information programmée à l'information à programmer. La fonction de lecture est identique à celle du plot de lecture, dans le sens où le lecteur du séquenceur dispose d'un oscillateur de puissance qui fournit l'énergie au plot programmable, dans le sens également où l'oscillateur de signal est soumis à l'influence du circuit résonant série du plot programmable. Toutes autres fonctions restant identiques par ailleurs, la différence intervient dans le fait que les cellules de sortie de la mémoire temporaire sont connectées à un groupe d'entrées d'un comparateur, l'autre groupe d'entrées étant raccordé aux entrées du séquenceur qui correspondent aux informations à programmer dans le plot programmable. S'il y a identité entre l'information à programmer et l'information enregistrée par le plot programmable, le séquenceur délivre un signal de coïncidence, autrement, le séquenceur délivre un signal de défaut. La fonction de programmation consiste à enregistrer dans le plot programmable l'information présente sur les lignes d'entrée du séquenceur de programmation, le processus se déroule comme suit: le séquenceur de programmation traduit sous forme d'un signal série l'information présente sur ses entrées parallèles, ce signal série transite par un modulateur identique à celui du plot programmable. Le signal issu du modulateur valide ou non la sortie de l'oscillateur de programmation au rythme du signal série issu de l'information parallèle à programmer, l'oscillateur de programmation et sa bobine associée créent un champ au rythme de l'information série issu du modulateur du séquenceur de programmation, la bobine de réception du signal de programmation est le siège d'une force électromotrice induite au rythme du signal issu du modulateur du séquenceur de programmation, cette force électromotrice est redressée et filtrée de manière à fournir un signal série, le démodulateur du plot programmable analyse ce signal, détecte l'information de synchronisation, la parité et transforme les signaux modulés, par exemple en largeur, en une succession de signaux tout ou rien; si l'information reçue est correcte le modulateur délivre un signal de validation. La succession de signaux tout ou rien transite par un convertisseur qui traduit ces signaux série en signaux parallèles. Ces signaux parallèles sont présentées à l'entrée de la mémoire et la commande de mémorisation est validée par le signal de validation issu de démodulateur du plot programmable. Il est à noter que l'énergie est fournie au plot programmable pendant ces opérations, par la partie lecture du séquenceur de programmation ou par le plot de lecteure, de façon permanente lorsqu'ils sont en regard l'un de l'autre.

Lorsque le plot programmable n'est ni devant un séquenceur de programmation, ni devant un plot de lecture, il ne reçoit pas le signal de puissance et, de ce fait, l'électronique et en particulier la mémoire du plot programmable n'est pas alimentée par une source de tension continue. Dans ce cas, l'information contenue dans la mémoire peut être sauvegardée par une pile raccordée uniquement sur l'alimentation de la mémoire, la tension développée par cette pile n'intervenant pas dans les fonctions de lecture (par des plots de lecture) ou de programmation par les séquenceurs de programmation. Une autre méthode de sauvegarde de l'information mémorisée, en l'absence d'un plot de lecture ou d'un séquenceur de programmation, consiste à utiliser des mémoires du type EAROM dont la fonction consiste à retenir des informations en l'absence de tension sur les bornes d'alimentation.

Les informations à enregistrer peuvent se présenter sous la forme d'un ou plusieurs mots de 8 à 16 bits. Dans le cas où la sauvegarde de la mémoire est constituée de mémoire EAROM il peut y avoir plusieurs mots de 8 ou 16 bits. Ces deux variantes (pile ou EAROM) de sauvegarde font partie de la présente invention.

Etant donné que pour le plot programmable comme pour le séquenceur de programmation les fonctions modulateur et démodulateur sont séparées, la programmation et le contrôle peuvent être faits simultanément, ce qui permet une programmation possible pendant le déplacement du plot programmable.

Le plot programmable se présente sous la forme d'un boitier métallique avec l'électronique surmoulée dans une résine.

Le séquenceur de programmation et le plot de lecture comportent deux prises, une pour les informations, l'autre pour l'alimentation.

Chaque produit est constitué d'un boitier métallique et l'électronique est entièrement surmoulée dans une résine.

La présente invention sera mieux comprise à l'aide de la description détaillée de plusieurs modes de réalisation pris comme exemples non limitatifs et illustrés par le dessin annexé, sur lequel:

– la figure 1 est un chronogramme de divers signaux apparaissant dans le dispositif de l'invention,

– la figure 2 est un schéma du plot programmable du dispositif de l'invention,

– la figure 3 est un schéma du plot de lecture du dispositif de l'invention,

– la figure 4 est un schéma du séquenceur du dispositif de l'invention,

– la figure 5 est le schéma d'une variante du plot programmable de la figure 2,

– la figure 6 est le schéma d'une variante du plot de lecture de la figure 3,

– les figures 7 et 8 sont des vues partielles en perspective et en coupe du plot programmable, et

– les figures 9 et 10 sont des vues partielles en perspectives et en coupe du séquenceur de programmation.

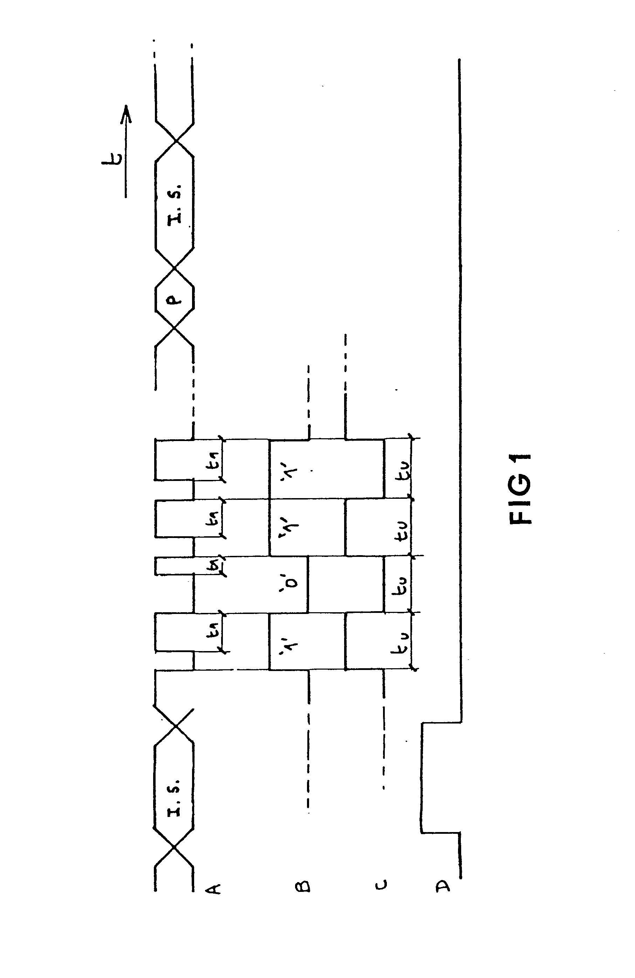

Sur le chronogramme de la figure 1, on a respectivement représenté aux lignes A, B, C et D: le signal issu du modulateur, le signal série émis ou reçu, le signal d'horloge, et le signal de validation du démodulateur. Sur cette figure 1, «I.S» signifie: «information de synchronisation», c'est-à-dire une combinaison unique de bits qui ne peut être confondue avec aucune autre information, et «P» signifie «bit de parité» qui est «0» ou «1» selon que le nombre total de bits d'une information complète est pair ou impair par exemple.

L'information à recevoir ou à transmettre est mise sous forme série (voir B figure 1). Un bit «1» correspond à un niveau de tension positive, un bit «0» à un niveau de tension nulle. La fonction du modulateur consiste, à l'intérieur d'un temps élémentaire (tu) (voir signal C sur la figure 1) à modifier le rapport cyclique entre un niveau de tension positive et un niveau de tension nulle. Si tl est la durée, dans l'intervalle de temps unitaire tu, du niveau de tension positive, il y aura bit «1» d'information lorsque: 0,55 tu<tl/tu<tu, il y aura bit «0» lorsque: 0 <tl/tu <0,45 tu.

Le modulateur module donc en largeur à l'intérieur d'un élément de temps unitaire tu, qui est la demi-période du signal d'horloge, la durée tl du niveau de tension positive (voir A figure 1). Pour une information donnée, le nombre de bits «1» ou «0» peut être pair ou impair. En effet, si n est le nombre de bits «1», si n/2=k (k= entier), la parité est paire, le bit de parité (P) sera un bit «1» sinon il sera un bit «0». Le démodulateur quant à lui, devra reconnaître une information de début de transmission afin de restituer le bit de niveau et de rang correct dans l'information série. Pour ce faire, le modulateur commence la transmission par une information de synchronisation qui consiste en une combinaison unique et spécifique de bits «1» et «0». Cette information de synchronisation ne peut être reconnue que par le démodulateur. Dans la suite de la transmission, vient la parité dont la valeur sera stockée en mémoire du démodulateur, puis la suite de bits «1» et «0» dont l'analyse de tl/tu donne lieu à un signal de tension positive ou nulle et, qui est le signal série restitué. Le démodulateur compte le nombre de temps élémentaires tu et, au terme de la valeur N qui correspond au nombre de bits à transmettre, calcule la parité de l'information reçue, et la compare au signal de parité mis en mémoire par le démodulateur précédemment. S'il y a égalité entre les deux valeurs de parité (reçue et calculée) le démodulateur génère un signal de validation (D sur la figure 1) dont la durée est égale à la durée de transmission de l'information de synchronisation qui précède l'information à transmettre suivante.

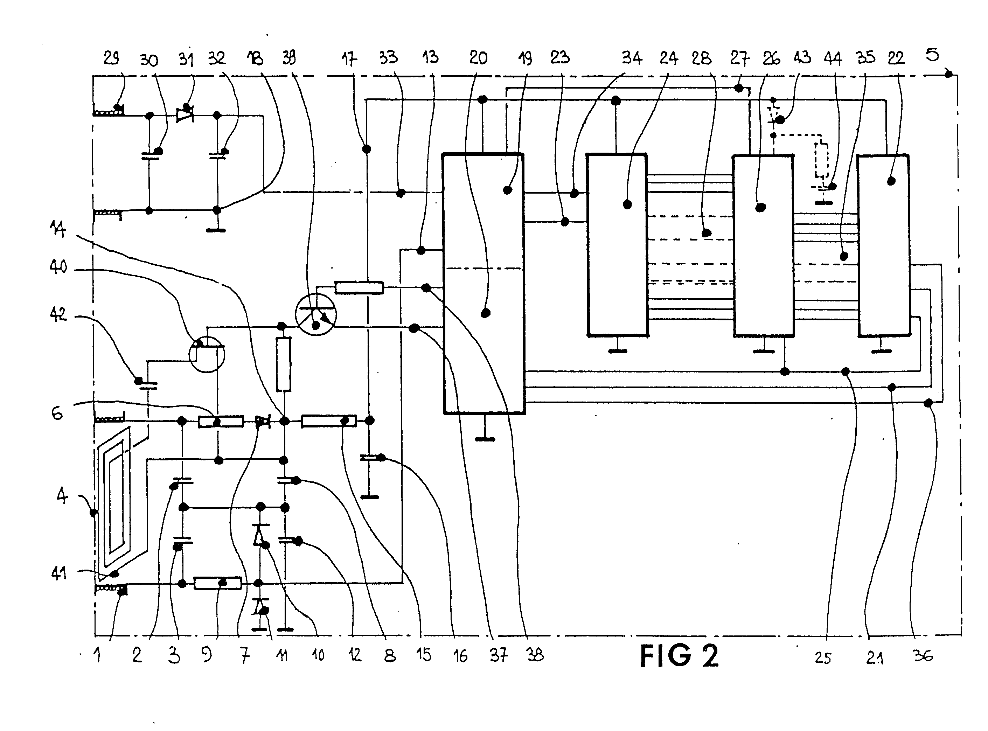

Sur la figure 2, qui est un schéma du plot programmable, les tracés en pointillés correspondent à l'utilisation d'une mémoire 26 dont la valeur enregistrée est sauvegardée par une pile 44 en l'absence de tension d'alimentation 17, sinon la mémoire 26 est du type EAROM. La bobine 1 de réception comprend deux enroulements, accordés chacun sur la fréquence de l'oscillateur de puissance 58 ou 101 par les condensateurs 2 et 3. Cette bobine 1 est orientée vers la face de transmission 4 du plot programmable 5. Le réseau de résistance 6, diode 7, condensateur 8 permet d'obtenir une tension positive au point 14. Le réseau résistance 15 et condensateur 16 permet d'obtenir la tension positive filtrée d'alimentation générale au point 17. Le réseau résistance 9, diodes 10 et 11, le condensateur 12 délivre une tension négative en 18 qui sera le commun de tension par la suite. Le Signal de puissance permet de fournir, en 13 après écrêtage par la diode 11, la fréquence d'horloge de base au modulateur 20 et au démodulateur 19. Le démodulateur 19 fournit l'horloge 23 au convertisseur série-parallèle 24. Le modulateur 20 fournit l'horloge 21 au convertisseur parallèle série 22. Le modulateur 20 fournit également le signal 25 de lecture de la mémoire 26. Le démodulateur 19 fournit le signal de validation 27 qui permet l'écriture de l'information parallèle présente sur les lignes 28 du convertisseur 24. Selon un mode de réalisation préféré, on utilise le circuit intégré HF 6409 comportant à la fois le modulateur et le démodulateur, ce circuit étant également utilisé dans le séquenceur et le plot de lecture décrit ci-dessous. La bobine 29 de réception su signal de programmation est accordée par le condensateur 30 sur la fréquence de programmation. La diode 31 et le condensateur 32 permettent d'obtenir l'information à mémoriser sous forme série (ligne 33). Le démodulateur 19 reçoit sur sa ligne 33 l'information à enregistrer, se synchronise sur l'information de synchronisation, teste l'information et sa parité, et génère le signal de validation 27. Le démodulateur 19 crée une suite de signaux «1» et «0» sur sa sortie de décodage 34. Ce signal est converti par le convertisseur 24 qui traduit le signal série 34 en une information sous forme parallèle sur ses sorties 28. Cette information parallèle est présente sur les lignes d'entrées de la mémoire 26. Le signal de validation 27 permet de transférer cette information dans les cellules de mémoire de la mémoire 26. Lorsque l'utilisateur ou le système de commande veut lire les données mémorisées dans la mémoire 26, le séquenceur de programmation ou le plot de lecture transmet au plot programmable un signal de puissance qui alimente en énergie ce plot programmable et lui fournit un signal d'horloge, et le modulateur 20 génère sur la ligne 25 un signal de demande de lecture à la mémoire 26 et au convertisseur 22. Dès réception de ce signal sur la ligne 25, la mémoire 26 délivre, sur ses lignes de sortie 35, l'information parallèle contenue dans cette mémoire 26. Cette information parallèle est présente sur les lignes 35 au convertisseur 22, qui les met sous forme série au rythme de l'horloge 21 et lorsque le signal de demande de lecture 25 est actif. Ce signal série transite par la ligne 36 vers le modulateur 20 qui inclut l'information de synchronisation, la parité et module en largeur ce signal 36. Le modulateur 20 dispose de deux sorties en opposition de phase 37 et 38. La sortie 37 est reliée à l'émetteur d'un transistor NPN 39, la base de ce transistor est reliée, par l'intermédiaire d'une résistance, à la sortie 38. Suivant la polarité des signaux 37 et 38, le transistor 39 est soit fortement bloqué soit saturé. Le collecteur du transistor 39 est relié à l'interrupteur statique 40 constitué, par exemple, d'un transistor à effet de champ ou d'un transistor V-MOS. Lorsque le transistor 39 est bloqué, l'interrupteur statique 40 est conducteur et, de ce fait, présente une faible résistance passante. Lorsque le transistor (39) est saturé, l'interrupteur statique 40 est ouvert. Lorsque l'interrupteur statique 40 est fermé, il met en œuvre un circuit résonant série constitué d'une spire gravée sur circuit imprimé 41 et d'un condensateur d'accord 42. La fréquene d'accord correspond à la fréquence de l'oscillateur de signal 95 du séquenceur de programmation 74 ou 51 du plot de lecture 45.

L'énergie est donc reçue par l'intermédiaire de la bobine 1, lorsqu'un séquenceur de programmation 74 ou un plot de lecture 45 est en regard du plot programmable 5, car cette bobine reçoit le signal de puissance émis par ces dispositifs. Lorsque le plot programmable ne reçoit plus ce signal de puissance, l'information mise dans les cellules de la mémoire 26 doit être maintenue. A cette fin, il est utilisé deux techniques possibles objets de l'invention: lorsque le signal de lecture 25 est à 0, les sorties 35 de la mémoire 26 sont mises en haute impédance. Une méthode de sauvegarde consiste à utiliser des mémoires du type EAROM, par exemple celles fabriquées par la société Xicor, dont la constitution technologique, à base de technologie MOS (Métal Oxyde Silicium), permet de résoudre ce problème. Une autre méthode de sauvegarde consiste à utiliser une pile 44 qui est découplée de l'ensemble du circuit par la diode 43 en l'absence du signal de puissance. Comme les sorties 35 de la mémoire 26 sont en haute impédance, le courant de maintien et de l'ordre de $10^{-12}$A, ce qui permet une durée de maintien de l'information de l'ordre de 10 ans.

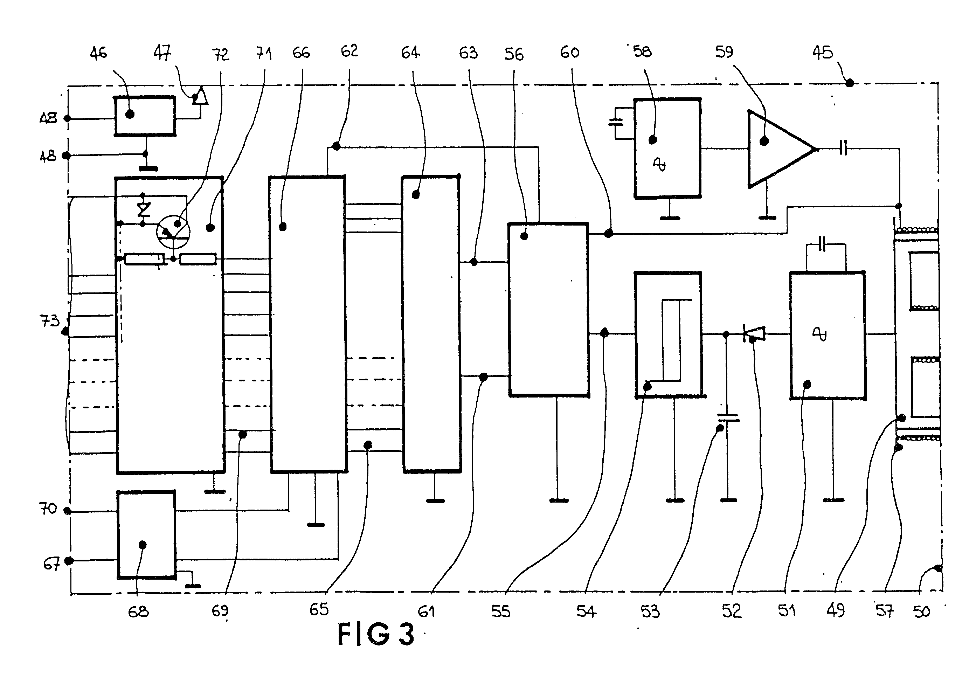

Le plot de lecture 45, dont le schéma est représenté sur la figure 3, comprend un régulateur de tension 46 qui fournit l'alimentation générale 47 aux circuits électroniques à partir d'une alimentation extérieure (non représentée) reliée aux bornes 48. Une bobine de signal 49 émet au voisinage de la face de transmission 50 un champ électromagnétique dont la fréquence correspond à la fréquence de l'oscillateur de signal 51. Le signal de sortie de l'oscillateur de signal 51 est détecté par la diode 52 et le condensateur 53. Le signal obtenu en 55 attaque un dispositif de mise en forme 54 qui est avantageusement un trigger de Schmitt et dont la sortie est reliée au démodulateur 56. Une bobine de puissance 57, concentrique à la bobine de signal 49, émet dans le voisinage de la face de transmission 50 un champ électromagnétique dont la fréquence correspond à la fréquence du signal de l'oscillateur de puissance 58, signal qui est amplifié par l'amplificateur de puissance 59. La fréquence du signal de puissance constitue la fréquence d'horloge 60 du démodulateur 56 du plot de lecture 45 et est la même que la fréquence d'horloge 13 du modulateur 20, du démodulateur 19 et du plot programmable 5. Ceci permet un synchronisme complet entre le plot programmable 5 et le plot de lecture 45. A partir de la fréquence d'horloge 60, le démodulateur 56 génère par division, par exemple dans le rapport 1/12, un autre signal d'horloge 61 et il génère d'autre part un signal de validation 62. Le démodulateur 56 analyse les informations de synchronisation, de parité, de rapport cyclique du signal 55 et, restitue un signal série binaire 63 formé d'une suite de signaux «1» et «0». Ce signal 63 attaque un convertisseur 64 piloté par l'horloge 61 qui fournit l'information sous forme parallèle 65.

Cette information 65 est véhiculée vers la mémoire temporaire 66, qui est avantageusement un registre à bascules de type D, et dont les cellules sont validées par le signal de validation 62. Un signal extérieur 67, produit par ledit système, et qui transite par l'adaptateur d'entrée 68, permet de mettre les sorties 69 de la mémoire 6 en haute impédance, l'adaptateur 68 comportant de façon connue en soi, un filtre à résistances et condensateurs et une diode Zener, par exemple, pour mettre en forme les signaux arrivant en 67 et 70. Un signal extérieur 70, qui transite par l'adaptateur 68, permet d'effacer la mémoire temporaire 66. Lorsque le signal 67 n'est pas actif, les sorties 69 de la mémoire 66 actionnent l'interface de sortie 71 constituée pour chaque sortie de circuits amplificateurs à transistors 72. Lorsque le plot programmable 5 est en regard du plot de lecture 45, la bobine d'émission de puissance 57 émet en permanence le signal de puissance vers la bobine de réception de puissance 1.

Les circuits du plot programmable 5 sont donc alimentés sous une tension continue apparaissant entre le point 18 et les points 14 et 17. Ceci a pour effet de mettre en œuvre au rythme de la fréquence du signal de puissance 13, le modulateur 20 qui envoie sur sa ligne 25 une demande de lecture. Dans ce cas, la mémoire 26 place sur ses lignes de sortie 35 l'information qu'elle a enregistrée.

Cette information sous forme parallèle 35 est mise sous forme série 36 par le convertisseur 22. Le signal série délivré à la sortie 36 transite par le modulateur 20 qui inclut une information de synchronisation, de parité et traduit les signaux «1» et «0» de l'information 36 en des signaux modulés en largeur, qui apparaissent sur les sorties 37, 38. De ce fait, par les transistors 39 et 40, le circuit résonant série 41, 42, 40, accordé sur la fréquence de signal de l'oscillateur 51 du plot de lecture 45 est mis ou non en œuvre. Lorsque l'interrupteur statique 40 est fermé, le champ électromagnétique de signal émis dans le voisinage de la face de transmission 50 par la bobine 49 est absorbé, par courants de Foucault, par le circuit résonant série 40, 41, 42.

Ceci diminue le niveau d'oscillation de l'oscillateur de signal 51 ce qui, après détection par le réseau 52, 53 et mise en forme par le circuit 54, permet d'obtenir un niveau «1» de tension sur la ligne 55. Lorsque l'interrupteur statique 40 est ouvert, le circuit résonant série n'est plus formé et, le champ électromagnétique de signal n'est plus absorbé, ce qui par le processus ci-dessus permet d'obtenir un niveau de tension «0» sur la ligne 55. Donc, sur la ligne 55, la succession de «1» et de «0» est l'image de la succession de «1» et «0» issue des lignes 37 et 38 du modulateur 20 du plot programmable 5. Ensuite, le démodulateur 56, le convertisseur 64, la mémoire temporaire 66, l'interface de sortie 71 restituent sur les lignes de sortie 73 l'information mise en mémoire dans la mémoire 26 et restituée par le plot programmable 5. L'échange d'informations entre le plot programmable 5 et le plot de lecture 45 est permanent tant que ces deux plots sont en regard l'un de l'autre. Sinon, la dernière information reçue, bonne, par le plot de lecture 45 reste en mémoire temporaire 66, lorsque les deux ne sont plus en regard.

Alors, le signal appliqué en 70 permet d'effacer le contenu de cette mémoire.

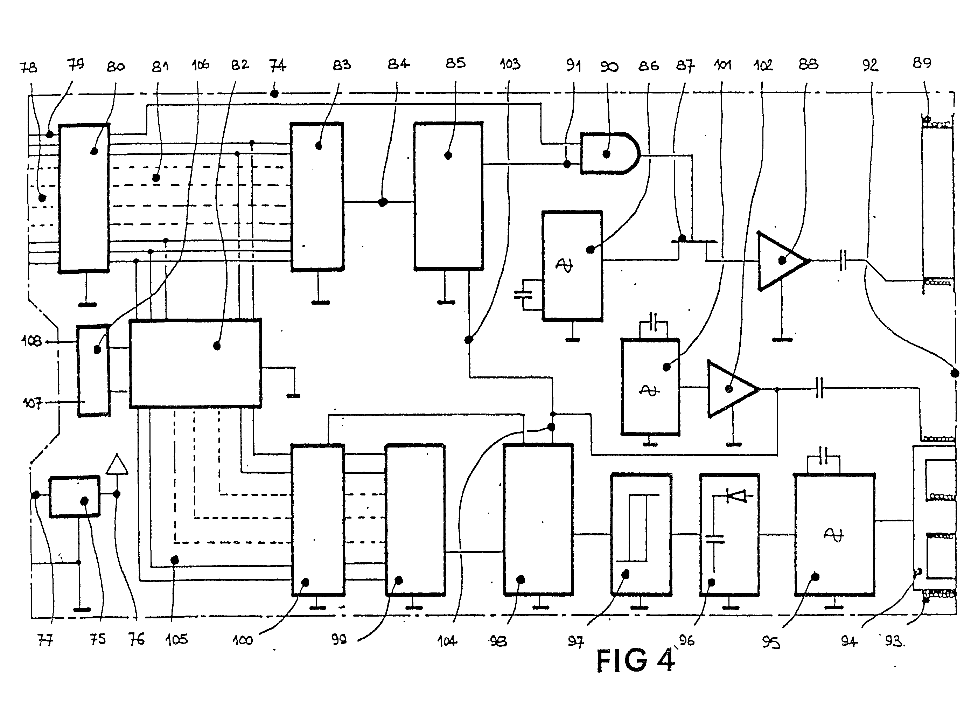

Le séquenceur de programmation 74, dont le schéma est représenté sur la figure 4, comprend un dispositif régulateur de tension 75 qui, à partir de la tension d'alimentation générale arrivant en 77, fournit l'alimentation 76 à l'ensemble de ses circuits électroniques. Les lignes d'entrées parallèles 78 reçoivent l'information à programmer et la demande de programmation 79 du système de commande (non representé) coopérant avec le dispositif de l'invention. Ces lignes transitent par un adaptateur 80 semblable à l'adaptateur 68. Les sorties 81 de cet adaptateur attaquent simultanément les entrées d'un comparateur 82 et les entrées d'un convertisseur parallèle série d'un modulateur 83. La sortie 84 du convertisseur 83 est reliée à l'entrée d'un modulateur 85 dont la fonction consiste à inclure une information de synchronisation, de parité et à moduler en largeur les signaux issus du convertisseur 83. Un oscillateur de programmation 86 oscille en permanence à la fréquence de programmation.

L'amplificateur de puissance 88 reçoit cette fréquence, au rythme du signal de sortie 91 du modulateur 85, par l'intermédiaire de l'interrupteur statique 87 lorsqu'il est validé par l'action du signal 79 sur la porte 90. La sortie de l'amplificateur 88 alimente la bobine de programmation 89, qui émet au rythme du signal 91 un champ électromagnétique à la fréquence de programmation, devant la face de transmission 92. La partie lecture du plot de programmation constituée de la bobine de puissance 93, de la bobine de signal 94, de l'oscillateur de signal 95, de la cellule de détection 96, de l'adaptateur 97, qui est avantageusement un trigger de Schmitt, du démodulateur 98, du convertisseur série-parallèle 99, de la mémoire temporaire 100, qui est également un registre à bascules D, de l'oscillateur de puissance 101, de l'amplificateur de puissance 102, joue le même rôle que la partie correspondante du plot de lecture 45. Il est à noter que la fréquence d'horloge 103 du modulateur 85 est la même que celle 104 du démodulateur 98, qui est la même que la fréquence d'horloge 13 du modulateur 20 et du démodulateur 19 du plot programmable 5, puisqu'il s'agit de la fréquence de l'oscillateur de puissance 101 du séquenceur de programmation 74. Dans ce cas, le séquenceur de programmation 74 est parfaitement synchrone avec le plot programmable 5. L'émission de l'information 78 à enregistrer et la réception de l'information programmée 105 est simultanée. En effet, le modulateur et le démodulateur de chacun des plots 5 et 74 agissent indépendamment l'un de l'autre.

Pour modifier l'information inscrite dans la mémoire 26 du plot programmable 5, il faut que sa circuiterie électronique soit alimentée, ce qui suppose que ce plot reçoive le signal de puissance, reçoive la fréquence de programmation, reçoive une information correctement formatée, que les fréquences d'horloge soient identiques. Toutes ces conditions forment une clé qui rend la modification du code impossible par un autre élément que le séquenceur de programmation. L'information reçue sur les lignes 105 de la mémoire temporaire 100 est aiguillée sur les autres entrées du comparateur 82. La comparaison se fait bit à bit. Si l'information sur les lignes 81 est identique à celle sur les lignes 105, le comparateur 82 génère un signal 107 qui transite par l'interface de sortie 106 semblable à l'interface 71. Autrement, la sortie défaut 108 est active, les sorties 107 et 108 étant reliées audit système de commande.

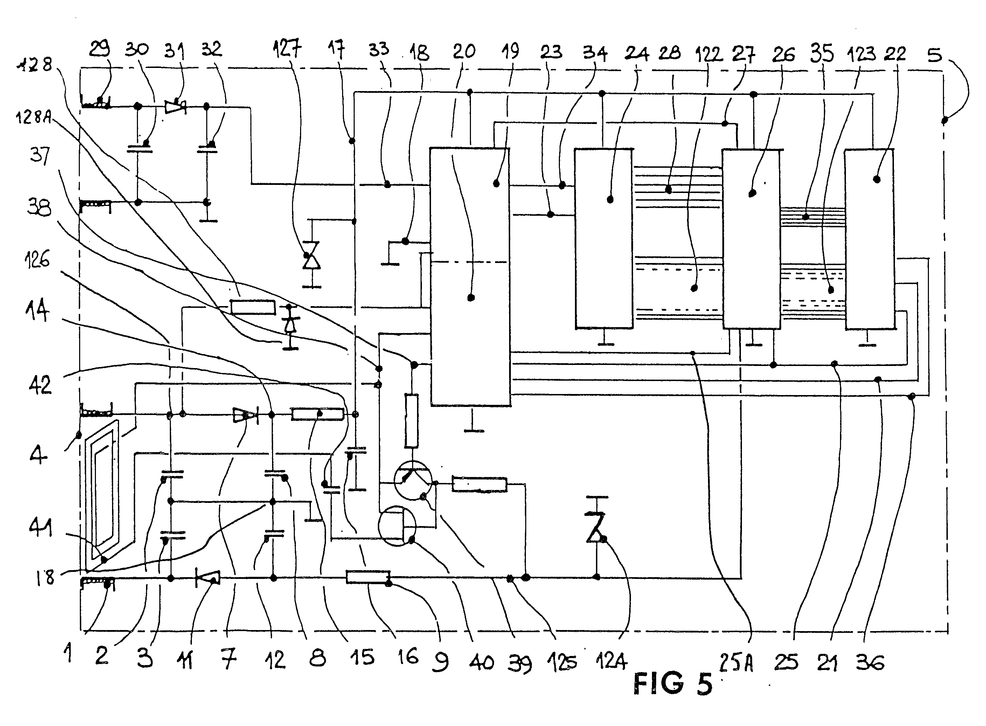

On a représenté sur la figure 5 le schéma d'un autre mode de réalisation du plot programmable. Les éléments identiques à ceux du mode de réalisation décrit ci-dessus et représenté sur la figure 2 portent les mêmes référence numériques. Le mode de réalisation de la figure 5 est essentiellement celui comportant une mémoire 26 de type EAROM.

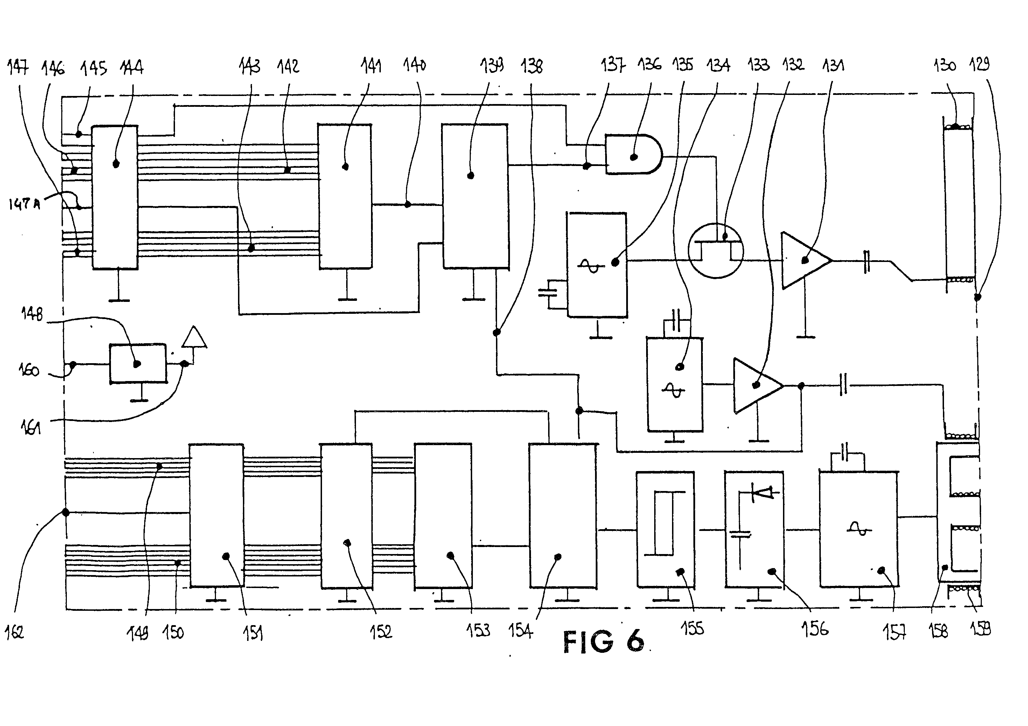

Dans ce plot programmable, la bobine 1 de réception du signal de puissance comprend deux enroulements accordés chacun sur la fréquence de l'oscillateur de puissance 135 du plot de lecture (voir figure 6) et de l'oscillateur de puissance 101 du séquenceur de programmation (voir figure 4) par les condensateurs 2 et 3 respectivement. Cette bobine 1 est orientée vers la face de transmission 4 du plot programmable 5. La diode 7 et le condensateur 8 permettent d'obtenir une tension redressée positive au point 14. Cette tension et filtrée et stabilisée par la résistance 15, le condensateur 16 et la diode Zener 127 et est disponible au point 17. La diode 1 et le condensateur 12 permettent d'obtenir une tension redressée négative qui et stabilisée par la résistance 16 et la diode Zener 124. Cette tension stabilisée est disponible au point 125 et sert à alimenter certains types de mémoires EAROM. Si l'on utilise des mémoires ne nécessitant qu'une tension d'alimentation positive, le point 125 devient le point commun des tensions.

Dans le cas de tensions positives et négatives, le point commun est, comme représenté sur la figure 5, le point 18 qui est le point commun des enroulements du bobinage 1.

Le signal de puissance, prélevé au point 126, est écrêté par la résistance 128 N la diode 128 A, et est renvoyé entant que signal d'horloge au modulateur 20 et au démodulateur 19. Le démodulateur 19 fournit sur la ligne 23 un signal d'horloge au convertisseur série-parallèle 24, et le modulateur 20 fournit un signal d'horloge sur la ligne 21 au convertisseur parallèle-série 22.

La bobine 29 de réception de fréquence de programmation forme avec le condensateur 30, un circuit résonant accordé sur la fréquence de programmation. La diode 31 et le condensateur 32 permettent d'obtenir par détection l'information à mémoriser qui est envoyée par la ligne 33 au démodulateur 19. Le démodulateur 19 se synchronise sur l'information de synchronisation (voir figure 1, ligne A), teste la parité, et génère un signal de validation sur la ligne 27. Les signaux de sortie du démodulateur sont envoyés par la ligne 34 au convertisseur 24. Le convertisseur 24 traduit l'information sous forme parallèle et l'envoie à la mémoire 26. Les données contenues dans l'information sont envoyées par les lignes 28 à la mémoire 26 à des adresses communiquées par les lignes d'adressage 122. Si par exemple chaque information est exprimée en seize éléments binaires, les huit éléments binaires de poids les plus faibles se rapportent à la donnée, et les huit éléments binaires de poids les plus forts se rapportent à l'adresse de cette donnée.

Lorsque l'utilisateur ou le système de commande veut lire les données mémorisées dans la mémoire 26, il envoie par l'intermédiaire du plot de lecture (voir ci-dessous la description de la figure 6) ou du séquenceur de programmation un signal de demande de lecture en plus de l'adresse de la mémoire 26 à laquelle on veut lire une donnée. L'adresse est transmise par le démodulateur 19 et le convertisseur 24 à la mémoire 26, tandis que le signal de demande de lecture est envoyé par le démodulateur 19 au modulateur 20 qui émet sur la ligne 25 un signal de demande de lecture et sur la ligne 25 A un signal de sélection de lecture qui met en basse impédance les sorties de la mémoire 26. Les données lues dans la mémoire 26 à l'adresse indiquée sont envoyées sur les lignes 123 et leurs adresses sur les lignes 35 au convertisseur 22 qui les met en série et les transmet sur la ligne 36 au modulateur 20 au rythme du signal d'horloge envoyé sur la ligne 21 par le modulateur 20. Le modulateur 20 inclut à ces informations une information de synchronisation, un bit de parité et les module. Le signal de sortie du modulateur 20 apparait sur ses deux sorties 37 et 38 qui sont en opposition de phase. La sortie 38 est reliée à l'émetteur d'un transistor PNP 39 dont la base est reliée par une résistance à la sortie 37. Suivant la polarité des signaux sur les sorties 37 et 38, le transistor 39 est fortement saturé ou bloqué. Lorsque le transistor 39 est bloqué, l'interrupteur statique 40 est conducteur et donc fermé, et lorsque le transistor 39 est saturé, l'interrupteur 40 est ouvert.

Lorsque l'interrupteur 40 est fermé, il met en œuvre un circuit résonant série constitué d'une spire gravée, sur un circuit imprimé 41, et d'un condensateur d'accord 42. La fréquence d'accord de ce circuit correspond à la fréquence de l'oscillateur de signal 95 du séquenceur de programmation 74 ou de l'oscillateur 157 du plot de lecture 129.

Le plot programmable reçoit en permanence par sa bobine 1 le signal de puissance qui permet de l'alimenter en énergie lorsqu'un séquenceur 74 ou un plot de lecture 129 est en regard de ce plot programmable. Lorsque le plot programmable ne reçoit plus ce signal de puissance, il n'est plus alimenté en énergie, mais les informations contenues dans les cellules de la mémoire 26 sont sauvegardées grâce au fait que cette mémoire est du type EAROM ou équivalent.

Le plot de lecture 45 de la figure 3 n'est utilisé que dans le cas où l'on doit, mémoriser un seul mot (une seule information) dans la mémoire 26, sont les lignes d'adresse 12 sont câblées de façon fixe pour utiliser toujours la même adresse.

Si l'on veut mémoriser plusieurs mots dans la mémoire 26, on utilise le circuit représenté sur la figure 6 pour le plot de lecture.

Le plot de lecture comporte un dispositif régulateur de tension 148 qui est relié par une ligne 160 à un circuit d'alimentation (non représenté). La sortie 161 du régulateur 148 fournit, de façon non représentée, la tension d'alimentation à tous les circuits du plot de lecture.

Le plot de lecture comporte dans sa partie programmation un adaptateur d'entrée (circuit de mise en forme) 144, semblable au circuit 80 de la figure 4, et ayant plusieurs entrées reliées au système de commande. Les entrées 146 reçoivent les données à faire mémoriser, les entrées 147 reçoivent l'adresse à laquelle doivent être mémorisées ces données, l'entrée 145 reçoit un signal d'autorisation de programmation, et l'entrée 147 A reçoit un signal de demande de lecture.

Les sorties 142 et 143 de l'adaptateur 144, correspondant respectivement à ses entrées 146 et 147, son reliées à un convertisseur parallèle-série 141 dont la sortie est reliée à un modulateur 139 identique à ceux décrits ci-dessus. La sortie de l'adaptateur 144, correspondant à l'entrée 147 A, est reliée au modulateur 139. La sortie du modulateur 139 est reliée à une première entrée d'une porte E T 136 dont l'autre l'entrée est reliée à une sortie de l'adaptateur 144 correspondant à l'entrée 145. La sortie de la porte 136 est reliée à l'électrode de commande d'un interrupteur statique 133 qui relie un oscillateur de programmation 135 oscillant en permanence à un amplificateur de puissance 131 dont la sortie est reliée à une bobine de programmation 130 qui émet au rythme du signal de sortie du modulateur, lorsque la porte 136 est validée par le signal de l'entrée 145, un champ électromagnétique à la fréquence de programmation, au-devant de la face 129 de transmission du plot de lecture.

La partie lecture du plot de lecture comporte une bobine de puissance 159 alimentée en puissance par un oscillateur 134 et un amplificateur de puissance 132, et une bobine de signal 158 reliée à un oscillateur de signal 157. L'oscillateur 157 est relié à une cellule de détection 156 dont la sortie et reliée par l'intermédiaire d'un circuit de mise en forme 155, avantageusement un trigger de Schmitt, à un démodulateur 154. La sortie du démodulateur 154 est reliée par un convertisseur série-parallèle 153 et par un registre 152 à une interface de sortie 151 similaire à l'interface 71 de la figure 3. L'interface 151 comporte également une entrée 162 permettant de valider ses sorties 149 et 150. Cette partie lecture est similaire à elle du plot de lecture 45 de la figure 3.

On notera que la sortie de l'amplificateur 132 est également reliée aux entrées de signaux d'horloge du modulateur 139 et du démodulateur 154, et que la fréquence du signal de l'oscillateur 134 est la même que celle du signal d'horloge du modulateur 20 et du démodulateur 19 du plot programmable.

L'émission des données à programmer (entrées 146) aux adresses désirées (entrées 147) peut se faire simultanément avec la réception des données programmées (sorties 150 de l'interface 151) aux adresses correspondantes (sorties 149), ce sous la commande du système de commande, du fait que le modulateur et le démodulateur du plot programmable et du plot de lecture agissent indépendamment l'un de l'autre. On peut ainsi contrôler qu'à chaque adresse en cause on a bien mémorisé ce que l'on voulait.

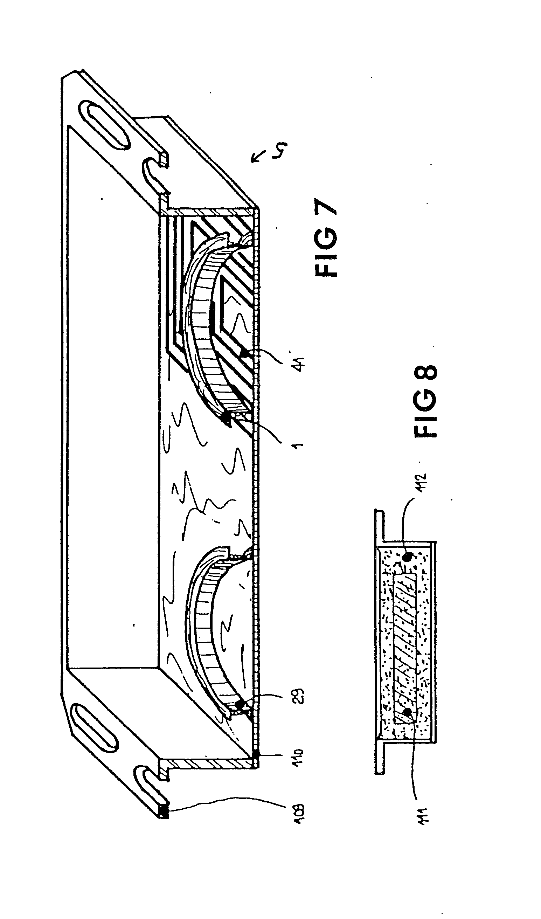

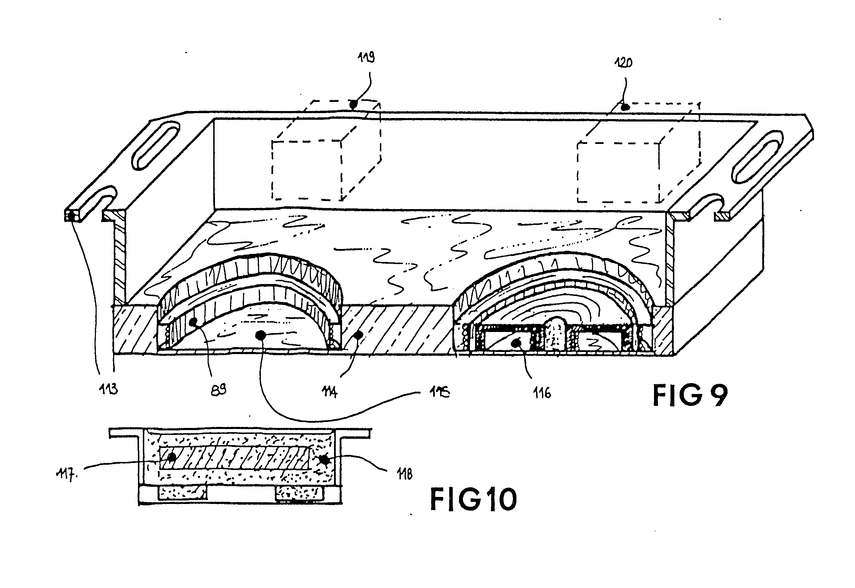

Le plot programmable 5 (voir figures 7 et 8) comprend une enveloppe métallique 109 sur laquelle est collée une face avant 110 sur laquelle la spire 41 est gravée. La bobine 1 de réception de puissance est posée sur la spire 41 alors que la bobine de réception 29 du signal de programmation se trouve désaxée. Le circuit électronique 111 se trouve surmoulé dans une résine 112, ce qui rend l'information contenue dans la mémoire 26 physiquement inaccessible, et qui donne un caractère d'inviolabilité à l'enregistrement. Ce plot 5 ne comporte aucune prise.

Le séquenceur de programmation 74 (voir figures 9 et 10) comprend une enveloppe métallique 113 surmontée d'une face avant en matière plastique. Cette face avant 114 contient deux trous lamés 115 et 116. A l'intérieur de 116 sont placées la bobine d'émission de puissance 93 et la bobine de signal 94.

Dans le trou lamé 115 se trouve la bobine d'émission 89 de la fréquence de programmation. Le circuit électronique 117 est surmoulé dans une résine 118. Le boitier 113 est équipé de deux prises 119 et 120.

Le plot de lecture 45 est identique, dans présentation, au séquenceur de programmation 74 aux différences près:
– il n'y a pas de bobine 89 du signal de programmation, le trou lamé 115 est supprimé;
– la longueur du boitier est la moitié de celle du boitier du séquenceur de programmation 74.

Le système objet de l'invention peut être utilisé dans des applications de codage dynamique d'objets, de direction, de repère de références. Il peut également être considéré comme une mémoire répartie, intégrante d'un automatisme, mais physiquement distincte.

Son intérêt et que l'on code directement l'élément sans avoir à faire une conversion entre l'élément et un code de support.

## Revendications

1. Système de transmission d'informations à transducteur programmable passif pour codage dynamique comportant au moins un dispositif mobile (5) (appelé par la suite «plot programmable») alimenté par induction en énergie par des dispositifs fixes (45, 74) (appelés par la suite «séquenceur de programmation» lorsqu'ils émettent des informations vers les dispositifs, et «plot de lecture» lorsqu'ils reçoivent des informations de ces dispositifs mobiles) avec lesquels il échange des informations, ces informations étant codées et modulant une onde porteuse caractérisé:

– en ce que le séquenceur de programmation comporte un «modulateur» ou dispositif de codage et de mise en forme d'informations, branché entre une source d'informations à programmer (78) et un dispositif (87) de modulation d'une onde porteuse (86);
– en ce que le séquenceur de programmation comporte également un «démodulateur» ou dispositif de décodage (98) pouvant décoder des informations telles que codées et mises en forme par le modulateur, branché entre un circuit de réception inductive d'informations (93 à 97) et un comparateur (82) qui est relié d'autre part à ladite source d'informations à programmer, ce comparateur comportant une sortie d'égalité (108) et une sortie de défaut (107);

– en ce que le plot programmable comporte un démodulateur (19), identique au démodulateur du séquenceur de programmation, branché entre un circuit de réception inductive d'informations (29 à 32) et un circuit de mémorisation à mémoire à semi-conducteur (26);

– en ce que le plot programmable comporte également un modulateur (20) identique à celui du séquenceur de programmation, ce modulateur étant branché entre le circuit de mémorisation et un dispositif (40) interrupteur statique branché dans un circuit inductif accordé (4, 42);

– en ce que le plot de lecture comporte un démodulateur (56) identique aux démodulateurs précités, ce démodulateur étant branché entre un circuit de réception inductive d'informations (49, 51, 52, 53) et une mémoire temporaire (66) effaçable restituant à la demande les informations qu'elle mémorise;

– en ce que le plot de lecture comporte un oscillateur de puissance (58, 59) alimentant de façon permanente par induction (57) le plot programmable lorsqu'ils sont en regard l'un de l'autre, la sortie de cet oscillateur étant également reliée à l'entrée de signaux d'horloge du démodulateur, et

– en ce que le séquenceur de programmation comporte un oscillateur de puissance (101, 102) alimentant par induction (93) de façon permanente, le plot programmable lorsqu'ils sont en regard l'un de l'autre, la sortie de cet oscillateur étant également reliée à l'entrée de signaux d'horloge du démodulateur (56) et du modulateur (98) de ce séquenceur.

2. Dispositif selon la revendication 1, caractérisé en ce que la borne d'alimentation du circuit de mémorisation (26) du plot programmable est reliée à une pile (44) découplée de la ligne d'alimentation (17) par un diode (43).

3. Dispositif selon la revendication 1, caractérisé en ce que le circuit de mémorisation du plot programmable est constitué par une mémoire EAROM à technologie MOS.

4. Dispositif selon l'une quelconque des revendications précédentes, caractérisé en ce que le codage réalisé par les modulateurs est une modulation en largeur d'impulsions avec insertion d'informations de synchronisation et de parité.

5. Dispositif selon l'une quelconque des revendications précédentes, caractérisé en ce que l'échange d'informations entre le plot programmable et le séquenceur et simultané.

6. Dispositif selon l'une quelconque des revendications précédentes, caractérisé en ce que l'échange d'informations entre le plot programmable et le plot de lecture est permanent tant qu'ils sont en regard l'un de l'autre et, lorsqu'ils ne sont plus en regard l'un de l'autre, la dernière information reçue bonne par le plot de lecture reste dans la mémoire temporaire (66) du plot de lecture.

7. Dispositif selon la revendication 1, caractérisé en ce que le plot de lecture comporte une partie de programmation (144, 141, 139, 136, 135, 134, 133, 131, 130) d'informations similaires à celle du séquenceur, et comportant pour chaque information des moyens de transmission de données (146) et d'adresses correspondantes (147), et une partie de lecture (151 à 159) restituant les données et leurs adresses (150, 149) sur un ordre de demande de lecture (147 A), ces deux parties recevant le même signal d'horloge et pouvant fonctionner simultanément.

**Patentansprüche**

1. System zum Übertragen von Informationen zu einem passiven programmierbaren Wandler zum dynamischen Kodieren mit wenigstens einer beweglichen Vorrichtung (5) (nachfolgend als «programmierbarer Block» bezeichnet), die durch Induktion von Energie durch feste Vorrichtungen (45, 74) gespeist wird (nachfolgend als «sequentielle Programmierschaltung» bezeichnet, denn sie schicken Informationen zu den Vorrichtungen, und als «Leseblock» bezeichnet, denn sie empfangen Informationen von den beweglichen Vorrichtungen), mit denen sie Informationen austauscht, wobei diese Informationen kodiert sind und eine Trägerwelle modulieren, dadurch gekennzeichnet,

– dass die sequentielle Programmierschaltung einen «Modulator» oder eine Vorrichtung zum Kodieren und zum Aufbereiten von Informationen aufweist, die an eine Informationsquelle zum Programmieren (78) und an eine Vorrichtung (87) zum Modulieren einer Trägerwelle (86) angeschlossen ist,

– dass die sequentielle Programmierschaltung ferner entweder einen «Demodulator» oder eine Vorrichtung zum Dekodieren (98) aufweist, die Informationen dekodieren kann, wenn sie vom Modulator kodiert und aufbereitet sind, die an eine Schaltung zum induktiven Empfang von Informationen (93 bis 97) und an einen Komparator (82) angeschlossen ist, der andererseits mit dieser Informationsquelle zum Programmieren verbunden ist, wobei der Komparator einen Gleichheitsausgang (108) und einen Fehlerausgang (107) aufweist;

– dass der programmierbare Block einen Demodulator (19) aufweist, der mit dem Demodulator der sequentiellen Programmierschaltung übereinstimmt und der an eine Schaltung zum induktiven Empfang von Informationen (29 bis 32) und an eine Speicherschaltung mit einem Halbleiterspeicher (26) angeschlossen ist;

– dass der programmierbare Block ferner einen Modulator aufweist, der mit demjenigen der sequentiellen Programmierschaltung übereinstimmt, wobei der Modulator an die Speicherschaltung und an eine statische Unterbrechungsvorrichtung (40) angeschlossen ist, die an eine passende induktive Schaltung (4, 42) angeschlossen ist;

– dass der Leseblock einen Demodulator (56) enthält, der den vorgenannten Demodulatoren entspricht, wobei dieser Demodulator zwischen einer Schaltung zum induktiven Empfangen von Informationen (49, 51, 52, 53) und einem zeitweiligen Speicher (66) angeschlossen ist, der auf Anfrage die von ihm gespeicherten Informationen in auslöschender Weise ersetzt;

– dass der Leseblock einen Leistungsoszillator (58, 59) enthält, der auf permanente Weise durch Induktion (57) den programmierbaren Block speist, wenn sich diese gegenüber liegen, wobei der Ausgang dieses Oszillators ferner mit dem Taktsignaleingang des Demodulators verbunden ist, und

– dass die sequentielle Programmierschaltung einen Leistungsoszillator (101, 102) enthält, der auf permanente Weise durch Induktion (93) den programmierbaren Block speist, wenn sich diese einander gegenüber liegen, wobei der Ausgang dieses Oszillators ferner mit dem Taktsignaleingang des Demodulators (56) und des Modulators (98) dieser sequentiellen Schaltung verbunden ist.

2. Vorrichtung nach Anspruch 1, dadurch gekennzeichnet, dass der Versorgungsanschluss der Speicherschaltung (26) des programmierbaren Blocks an eine Zelle (44) angeschlossen ist, die von der Versorgungsleitung (17) durch eine Diode (43) entkoppelt ist.

3. Vorrichtung nach Anspruch 1, dadurch gekennzeichnet, dass die Speicherschaltung des programmierbaren Blocks aus einem EAROM-Speicher in MOS-Technologie besteht.

4. Vorrichtung nach einem der vorhergehenden Ansprüche, dadurch gekennzeichnet, dass die Kodierung, die durch die Modulatoren bewerkstelligt wird, eine Impulslängenmodulation mit Einsatz von Synchronisationsinformationen und Paritätsinformationen ist.

5. Vorrichtung nach einem der vorhergehenden Ansprüche, dadurch gekennzeichnet, dass der Informationsaustausch zwischen dem programmierbaren Block und der sequentiellen Schaltung gleichzeitig stattfindet.

6. Vorrichtung nach einem der vorhergehenden Ansprüche, dadurch gekennzeichnet, dass der Informationsaustausch zwischen dem programmierbaren Block und dem Leseblock ständig stattfindet, wenn diese einander gegenüber liegen, wobei in dem Fall, in dem diese einander nicht länger gegenüber liegen, die letzte Information, die gut von dem Leseblock empfangen worden ist, in dem zeitweiligen Speicher (66) des Leseblocks verbleibt.

7. Vorrichtung nach Anspruch 1, dadurch gekennzeichnet, dass der Leseblock einen Programmierabschnitt (144, 141, 139, 136, 135, 134, 133, 131, 130) für Informationen enthält, die denen der sequentiellen Schaltung ähneln, und für jede Information Übertragungsmittel für Daten (146) und für entsprechende Adressen (147) enthält, sowie einen Leseabschnitt (151 bis 159) enthält, der die Daten und ihre Adressen (150, 149) in einer Reihenfolge der Leseabfrage (147 A) aufbereitet, wobei die beiden Abschnitte dasselbe Taktsignal empfangen und gleichzeitig arbeiten können.

## Claims

1. An information transmission system with passive programmable transducer for dynamic coding comprising at least one mobile device (5) (called hereafter "programmable hub") supplied by energy induction by fixed devices (45, 74) (called hereafter "programming sequencer" when they send information to the devices and "reading hub" when they receive information from these mobile devices) with which they exchange information, this information being coded and modulating a carrier wave, characterized

– in that the programming sequencer comprises a "modulator" or information coding and shaping device connected between the source of information to be programmed (78) and a device (87) for modulating a carrier wave (86);

– in that the programming sequencer also comprises a "demodulator" or decoding device (98) capable of decoding the information such as coded and shaped by the modulator connected between an inductive information receiving circuit (93 to 97) and a comparator (82) which is further connected to said source of information to be programmed, this comparator comprising an equality output (108) and a fault output (107);

– in that the programmable hub comprises a demodulator (19), identical to the demodulator of the programming sequencer, connected between an inductive information receiving circuit (29 to 32) and a storage circuit with semi-conductor memory (26);

– in that the programmable hub also comprises a modulator (20) identical to that of the programming sequencer, this modulator being connected between the storage circuit and a static switching device (40) connected in a tuned inductive circuit (4, 42);

– in that the reading hub comprises a demodulator (56) identical to the above mentioned demodulators, this demodulator being connected between an inductive information receiving circuit (49, 51, 52, 53) and a temporary erasable memory (66) restoring as required the information it has stored;

– in that the reading hub comprises a power oscillator (58, 59) permanently supplying the programmable hub with power by induction (57) when they are opposite each other, the output of this oscillator being also connected to the clock signal input of the demodulator, and

– in that the programming sequencer comprises a power oscillator (101, 102) permanently supplying the programmable hub by induction (93) when they are opposite each other, the output of this oscillator being also connected to the clock signal input of the demodulator (56) and of the modulator (98) of the sequencer.

2. Device according to claim 1, characterized in that the power supply terminal of the storage circuit (26) of the programmable hub is connected to a battery (44) decoupled from the power supply line (17) by a diode (43).

3. Device according to claim 1, characterized in that the storage circuit of the programmable hub is formed by an EAROM store formed by MOS technology.

4. Device according to any one of the preceding claims, characterized in that the coding provided by the modulator is pulse width modulation with insertion of synchronizing and parity information.

5. Device according to any one of the preceding claims, characterized in that the exchange of information between the programmable hub and the sequencer is simultaneous.

6. Device according to any one of the preceding claims, characterized in that the exchange of information between the programmable hub and the reading hub is permanent as long as they are opposite each other and, when they are no longer opposite each other, the last information received correct by the reading hub remains in the temporary store (66) of the reading hub.

7. Device according to claim 1, characterized in that the reading hub comprises an information programming part (144, 141, 139, 136, 135, 134, 133, 131, 130) similar to that of the sequencer and comprising, for each piece of information, data (146) and corresponding address (14) transmission means and a reading part (151 to 159) restoring the data and the adresses thereof (150, 149) on a reading request order (147A), these two parts receiving the same clock signal and being capable of operating simultaneously.

**FIG 1**

FIG 2

FIG 3

FIG 4

0 055 639

FIG 5

FIG 6.

S 0 055 639

FIG 7

FIG 8

25

FIG 9

FIG 10

0 055 639